# EUROPEAN PATENT SPECIFICATION

(11) **EP 4 048 044 B1**
(45) Date of publication and mention of the grant of the patent: **30.07.2025**
(21) Application number: 19949110.1
(22) Date of filing: 18.10.2019
(51) Int. Cl.: H05K 13/02, H05K 13/08, H05K 13/00, B65G 1/137

(54) **STOREROOM**
LAGERRAUM
ENTREPÔT

(43) Date of publication of application: 24.08.2022
(73) Proprietor: Fuji Corporation, Chiryu-shi, Aichi 472-8686 (JP)
(72) Inventor: ITO, Akinobu, Chiryu-shi, Aichi 472-8686 (JP)
(74) Representative: Grünecker Patent- und Rechtsanwälte PartG mbB
(86) International application number: PCT/JP2019/041124
(87) International publication number: WO 2021/075050

(56) References cited:
- EP-A1- 3 238 514
- WO-A1-2019/138548
- WO-A1-2019/142336
- JP-A- 2008 033 049
- JP-A- 2018 016 434
- JP-A- 2018 501 167
- US-A1- 2017 073 159

## Description

### Technical Field

This specification discloses technology related to a storage compartment.

### Background Art

The component management support system described in Patent Reference 1 is provided with an imaging section, a display section, and a support information display processing section, and supports the loading and unloading of a component in a component storage location by an operator. In more specific terms, the display section, based on information captured by the imaging section, overlays support information to support the loading and unloading of the component in the component storage location over an image of the component storage location, or displays the support information within the field of vision of the operator. The support information display processing section also overlays and displays support information on the display section.
Patent Reference 2 provides a further storage compartment according to the prior art.

### Citation List

### Patent References

Patent Reference 1: JP-A-2018-56253
Patent Reference 2: WO 2019138548

### Summary of Invention

### Technical Problem

In a storage compartment in which the storage operation of storing a loaded object in a storage section is automated, an operator must place the object in a given placing position to enable the object to be handled by a moving section which moves objects. The external dimensions of an object to be loaded in the storage compartment may vary depending on the type of object, and the external dimensions of the object may determine the appropriate loading position for the object.

In a storage compartment disclosed in this specification, the storing operation of storing a loaded object in a storage section is automated, and the storage compartment is configured to guide the operator in selecting the appropriate loading position based on the type of object, for objects with varying external dimensions.

### Solution to Problem

The invention is set out in the appended set of claims. This specification discloses a storage compartment provided with a placing section, a guiding section, a storage section, and a moving section. The placing section on which an object is temporarily placed when the object is being received to be used by a board work machine that is configured to perform given board work on a board is loaded. The guiding section is configured to display on the placing section a placement position for each type of the object with external dimensions that differ from other types of the objects to guide an operator to select the placement position that can accommodate the object such that the placing position enables a moving section to handle the object.. The storage section stores the object. The moving section moves the object placed in the placing section into the storage section. The guiding section uses a projecting device to project an external shape of each type of the object from above the placing section, or the guiding section is configured to use a light-emitting device to cause a light-emitting element provided in the placing section to emit light in a form of the external shape of each type of object.

### Advantageous Effects

The storage compartment is provided with a placing section, a guiding section, a storage section, and moving section. The storage compartment automates the storage operation of storing a loaded object in the storage section, and provides guidance to the operator on the appropriate loading position based on the type of object, for objects with varying external dimensions.

### Brief Description of Figures

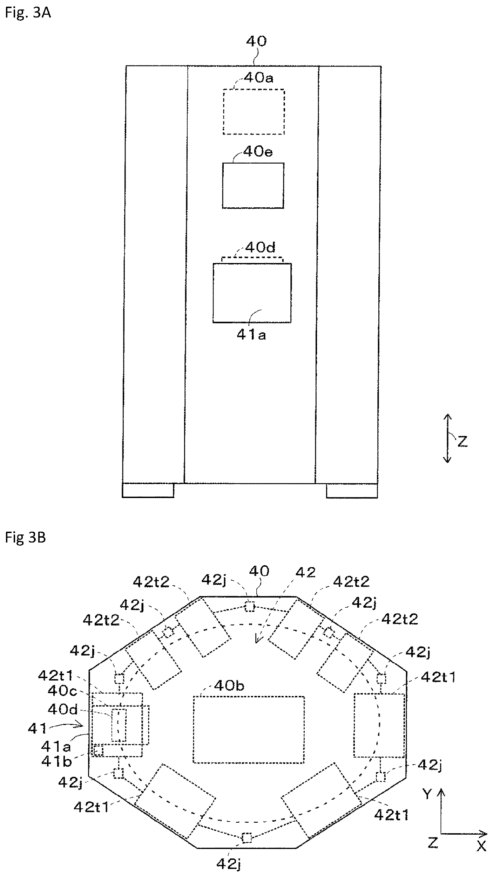

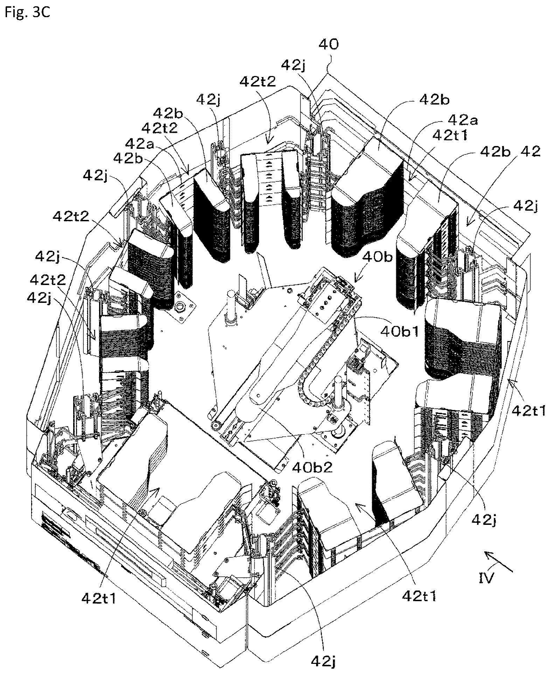

Fig. 1
   This is a configuration diagram showing a configuration example of a board production device.
Fig. 2
   This is a plan view showing an example of the state in which an object is stored in a storage case in the intake section.
Fig. 3A
   This is a front view showing an example of the storage component.
Fig. 3B
   This is a plan view of the storage compartment in Figure 3A.
Fig. 3C
   This is a perspective view of the storage compartment in Figure 3A.
Fig. 4
   This is a side view showing the storage compartment in Fig. 3C in the IV arrow direction.
Fig. 5
   This is a block diagram showing an example of a control block of the storage compartment.
Fig. 6A
   This is a flowchart showing an example of a control procedure for an object loading operation.
Fig. 6B
   This is a flowchart showing an example of a control procedure for an object unloading operation.
Fig. 7
   This is a schematic diagram showing an example of the placing position and external shape for each object type that is projected in the placing section.
Fig. 8
   This is a schematic diagram showing an example of the relationship between projection direction and external shape.
Fig. 9
   This is a schematic diagram showing an example of a format in which placing position and external shape for each object type is displayed by light emitted by light-emitting elements.

### Description of Embodiments

### 1. Embodiments

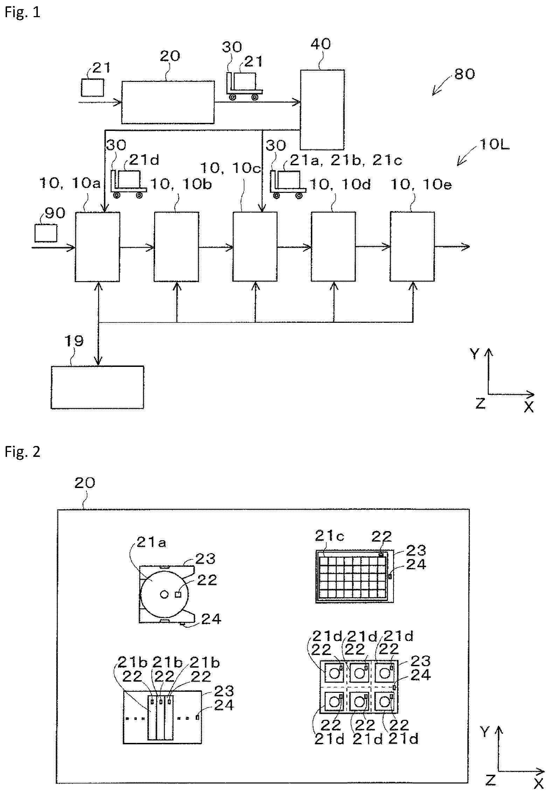

As shown in Fig. 1, in this embodiment, storage compartment 40 is provided in board production device 80. Board production device 80 is provided with board work line 10L, intake section 20, conveying vehicle 30, and storage compartment 40.

### 1-1. Board work line 10L

In board work line 10L, given board work operations are performed on board 90. There are no restrictions on the type or number of board work machines 10 comprising board work line 10L. As shown in Fig. 1, in this embodiment board work line 10L comprises multiple (five) board work machines 10, including printer 10a, print inspecting device 10b, component mounting device 10c, reflow oven 10d, and exterior inspecting device 10e. Board 90 is conveyed by the board conveying device to these devices in sequence.

Printer 10a prints solder at multiple component mounting positions on board 90. Solder printed on board 90 has a given viscosity and functions as bonding material to bond board 90 with components mounted on board 90. As shown in Fig. 2, solder container 21d stores solder. Solder container 21d can consist of such containers as a closed-end cylinder or tubular sealable container.

Print inspecting device 10b inspects the condition of solder printed by printer 10a. Component mounting device 10c mounts multiple components on board 90, on which solder was printed. There can be one or more component mounting device 10c. When multiple component mounting devices 10c are provided, the operation of mounting multiple components on board 90 can be divided between the multiple component mounting devices.

Component mounting device 10c is provided with a component supplying device that supplies the components to be mounted on board 90. As shown in Fig. 2, the component supplying device can supply components using modules such as feeder 21b provided with reel 21a, and tray 21c. Component tape (carrier tape) storing components is wound around reel 21a. Reel 21a is detachably attached to feeder 21b in such a way that reel 21a can rotate. The end of the component tape is fed out as far as a component removing section provided on feeder 21b, and components are supplied in sequence.

Reel 21a can supply comparatively small components, such as chip components. Components are arranged in tray 21c. Tray 21c can supply comparatively large components such as quad flat package (QFP) and ball grid array (BGA) components. Reflow furnace 10d heats board 90 once multiple components have been mounted on board 90 using component mounting device 10c, causing the solder to melt and adhere. External inspecting device 10e inspects the mounting condition of the multiple components mounted by component mounting device 10c.

Board work line 10L conveys boards 90 to multiple (five) board work devices 10 in sequence, where they undergo production processes including inspection processes, thereby producing board products. Board work line 10L can be provided with board work machines 10 such as function inspecting devices, buffer devices, board supplying devices, board inverting devices, shield mounting devices, adhesive applying devices, and ultraviolet irradiating devices, as required.

The multiple (five) board work machines 10 and management device 19 comprising board work line 10L can communicate with each other through a wired or wireless communication section. Management device 19 controls the multiple (five) board work machines 10 that make up board work line 10L and monitors the operating state of board work line 10L. Management device 19 records control data used in controlling the multiple (five) board work machines 10. Management device 19 transmits control data of multiple (five) board work machines 10. Each of the multiple (five) board work machines 10 transmit their operating state and production status to management device 19.

### 1-2. Intake section 20 and conveying vehicle 30

When object 21 arrives at intake section 20, given intake operations are performed. After that, object 21 is stored in storage case 23, loaded into conveying vehicle 30, and conveyed to storage compartment 40, for example. After object 21 is stored in storage compartment 40, object 21 will be supplied to board work line 10L when needed.

Board work line 10L is provided with printer 10a. Solder container 21d, which stores solder, is object 21 in this case. Board work line 10L is provided with component mounting device 10c. Reel 21a, around which is wound component tape, which stores components, is object 21 in this case.

Feeder 21b, to which reel 21a is detachably attached in such a way that reel 21a can rotate, is also an object 21. Tray 21c, in which components are arranged, is also an object 21. A holding member, which holds components, is also an object 21. A holding member can be a member such as a suction nozzle or chuck. A holding member storage device (such as a nozzle station), which contains holding members, is also an object 21. Any object can be an object 21 as long as it is used by a board work machine 10 to perform given board work operations on board 90.

Object 21 is provided with ID code 22. ID code 22 records identifying information that identifies object 21. One-dimensional codes, two-dimensional codes, wireless tags, or other forms of code can be used as ID code 22. When object 21 arrives at intake section 20, an intake section 20 operator can perform operations such as using an object management device to issue identifying information. The operator can also use a barcode reader or similar tool to read a barcode provided on object 21 by its supplier (vendor). The operator can then acquire object information about the object 21 from a database containing a registry of object information relating to objects 21. From among available identifying information and object information, the operator uses an object management device to record at least identifying information to ID code 22.

The intake section 20 operator attaches ID code 22, which at least records identifying information, to object 21 and then stores object 21 in storage case 23. Storage case 23 can take various forms, as long as it can store at least one object 21. Storage case 23 is provided with specifying code 24. Specifying code 24 records specifying information for specifying storage case 23. One-dimensional codes, two-dimensional codes, wireless tags, or other forms of code can be used as specifying code 24.

When storing object 21 in storage case 23, an operator reads specifying code 24 using a reading device, and then reads ID code 22 on object 21 using a reading device. This links the specifying information that specifies which storage case 23 contains object 21 with identifying information that identifies object 21. The linked information is transmitted to the memory section of management device 19 and is recorded there.

The intake section 20 operator loads storage case 23 containing object 21 in conveying vehicle 30. Conveying vehicle 30 can be towed by the operator, for example, or by other means. An Automatic Guided Vehicle (AGV) is another possible means of towing conveying vehicle 30. Conveying vehicle 30 of this embodiment is an unmanned conveying vehicle. Board work line 10L, intake section 20, conveying vehicle 30, and storage compartment 40 can communicate with each other through a wired or wireless communication section. When object 21 is loaded into conveying vehicle 30, management device 19 issues a transport command to conveying vehicle 30. The transport command includes the transport destination of object 21. Management device 19 determines the transport destination by selecting a storage compartment 40 that is capable of storing object 21. When conveying vehicle 30 receives the transport command, it transports object 21 to the storage compartment 40 selected as the transport destination.

Conveying vehicle 30 can transport object 21 without using storage case 23. A worker can transport object 21 without using conveying vehicle 30. At least some of the operations performed by the operator can be automated using transport devices (e.g., conveyor belts), actuators (e.g., robot arms), and object management devices.

### 1-3. Storage compartment 40

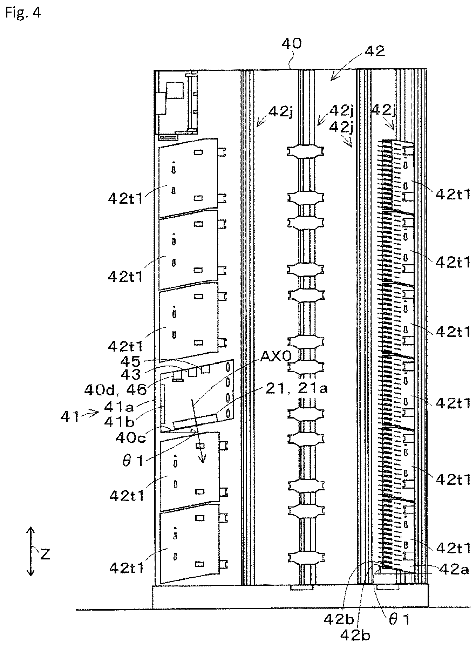

Storage compartment 40 can take various forms, as long it can store object 21. As shown in Figs. 3A to 3C, storage compartment 40 of this embodiment, for example, is in the form of an octagonal prism. In Fig. 3C, the upper section of storage compartment 40 is open, and the interior of storage compartment 40 is as shown in the drawing. Fig. 4 is a schematic diagram of the interior of storage unit 40 viewed in the direction of arrow IV shown in Fig. 3C, and mainly illustrates the positional relationship of loading section 41 and storage section 42.

Storage compartment 40 is provided with loading section 41, storage section 42, control device 40a, and movement device 40b. Loading section 41 is provided with aperture section 41a and placing section 40c. Storage section 42 is provided with two types of storage units: first storage unit 42t1 and second storage unit 42t2. Storage compartment 40 can be provided with operator detecting device 41b in loading section 41. Storage compartment 40 can be provided with projecting device 43 or light-emitting device 44. Storage compartment 40 can be provided with measurement device 45 and imaging device 46.

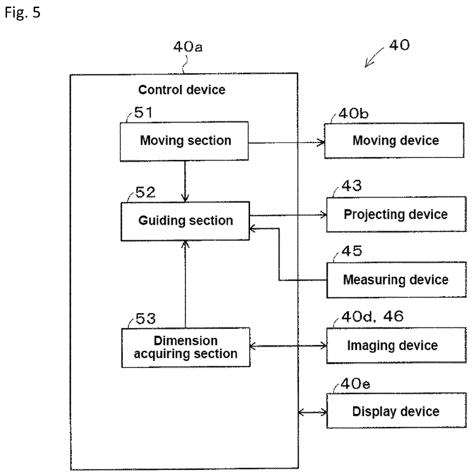

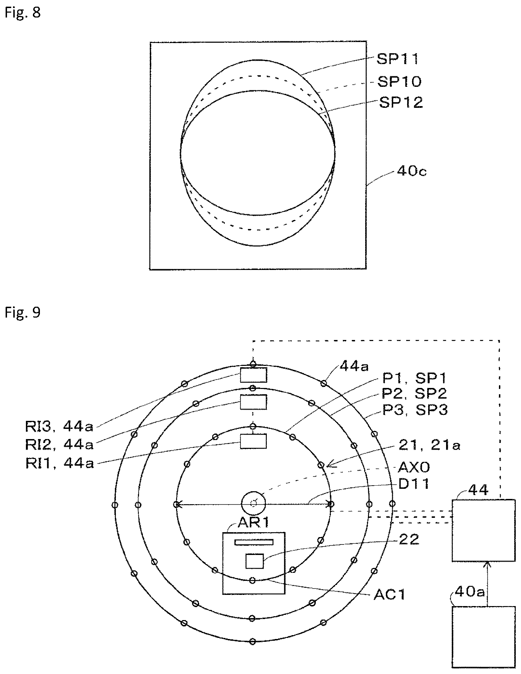

As shown in Fig. 5, when considered as a control block, control device 40a is equipped with moving section 51, guiding section 52, and dimension acquiring section 53. Storage compartment 40 can be provided with reading device 40d. Storage compartment 40 can be provided with display device 40e. As shown in Figs. 3A through 3C, 4, and 5, storage compartment 40 of this embodiment is equipped with all devices and parts described above except for the light-emitting device 44 shown in Fig. 9. Imaging device 46 also serves as reading device 40d.

### 1-3-1. Schematic configuration of storage component 40

Loading section 41 is equipped with aperture section 41a, operator detecting section 41b, and placing section 40c, and loads at least object 21. As shown in Fig. 3A, aperture section 41a is provided on the front surface of storage compartment 40. Object 21 is loaded into storage compartment 40 through aperture section 41a. In this embodiment, aperture section 41a is a dual-use entry-exit aperture through which object 21 can be loaded or unloaded. Object 21 can also be unloaded through aperture section 41a. Aperture section 41a is larger than object 21 so as to enable object 21 to be loaded and unloaded.. Storage compartment 40 can be equipped with an aperture section and unloading aperture different from aperture 41a.

As shown in Figs. 3B and 4, operator detecting device 41b and placing section 40c are located in the work space near aperture section 41a. Operator detecting device 41b detects the loading of object 21 by an operator through aperture section 41a, where object 21 is loaded. Operator detecting device 41b can take various forms, as long as it can detect loading of object 21 by an operator. Operator detecting device 41b can consist of, for example, an optical sensor (such as a laser sensor) provided with a light-emitting device and a light-receiving device. In this case, operator detecting device 41b can detect the loading of object 21 by an operator when the operator blocks the laser light beamed from the light-emitting device to the light-receiving device.

Object 21 is temporarily placed on placing section 40c when object 21 is loaded through aperture section 41a. The operator carries in object 21 through aperture section 41a and places object 21 on placing section 40c. When object 21 is unloaded through aperture section 41a, object 21 is placed on placing section 40c. Like the loading operation, the operator carries out object 21 placed on placing section 40c through aperture 41a to unload object 21.

As shown in Fig. 4, reading device 40d is provided above placing section 40c. Reading device 40d acquires identifying information to identify object 21 by reading ID code 22 provided on object 21. Reading device 40d can consist of any known reading device (e.g., a code reader that reads one-dimensional or two-dimensional codes, or a wireless reader that communicates wirelessly with wireless tags). When object 21 is loaded through aperture section 41a, reading device 40d can read ID code 22 provided on object 21 and from the identifying information and object information ID code 22 contains, can at least acquire identifying information.

Storage section 42 stores object 21. Storage section 42 can take various forms, as long as it can store object 21. For example, if object 21 consists of reel 21a, it is desirable to provide storage section 42 with main body section 42a and partition section 42b, as shown in Figs. 3C and 4. Main body section 42a forms a U-shape when viewed in the vertical (Z-axis) direction. Partition section 42b protrudes upward at a given angle with respect to main body section 42a, and can store reel 21a. Partition section 42b is angled so as to keep reel 21a from falling out.

Partition sections 42b are provided in multiple pairs for each storage unit (in Fig. 4, 30 partition sections 42b making up 15 pairs) and can store multiple (15) reels 21a. Each of the multiple pairs (15 pairs) of partition sections 42b is equipped with the two partition sections 42b separated in such a way that they do not interfere with moving device 40b. In Figs. 3C and 4, for convenience, only a portion of the members have been assigned reference sign numbers, and not all members have been assigned reference sign numbers.

As shown in Figs. 3B and 3C, storage section 42 of this embodiment forms an ellipse when viewed in the vertical (Z-axis) direction. Additionally, storage section 42 of this embodiment is provided with two types of storage unit, which are first storage unit 42t1 and second storage unit 42t2. Multiple units of first storage unit 42t1 and second storage unit 42t2 are each arranged in the vertical (Z-axis) direction. First storage unit 42t1 is wider than second storage unit 42t2, and first storage unit 42t1 can hold a larger reel 21a than second storage unit 42t2 can hold.

As shown in Figs. 3C and 4, first storage unit 42t1 is connected in the vertical direction (Z-axis direction) by connecting section 42j. Second storage unit 42t2 is also connected in the vertical direction (Z-axis direction) by connecting section 42j. First storage units 42t1 which are adjacent to other first storage units 42t1 are connected via connecting sections 42j, and second storage units 42t2 which are adjacent to other second storage units 42t2 are also connected by connecting sections 42j. First storage units 42t1 which are adjacent to second storage units 42t2 are also connected by connecting sections 42j.

The type, number, and layout of storage units can be modified as needed. The shape and size (width, depth, and height) of storage units can be set to accommodate the object 21 to be stored, and storage section 42 can store objects 21 other than reels 21a. Object 21 can be stored in any compatible storage unit. If board production device 80 is equipped with multiple storage compartments 40, object 21 can be stored in any storage compartment 40 provided with a compatible storage unit.

Control device 40a is provided with a known calculation device and memory device, and is configured with control circuits. Control device 40a is configured to communicate with and control moving device 40b, imaging device 46 which also serves as reading device 40d, display device 40e, operator detecting device 41b, projecting device 43, and measuring device 45. If storage compartment 40 is provided with light-emitting device 44 as shown in Fig. 9 instead of projecting device 43, control device 40a can also control light-emitting device 44.

Control unit 40a can record object information regarding object 21 and transmit the object information to management device 19. For example, if object 21 is reel 21a, object information can include information such as the following about the components stored on reel 21a: component type, number of components (remaining number), reel diameter, reel thickness, model and supplier (vendor), and expiration date.

Moving device 40b can move object 21 loaded in loading section 41 to storage section 42. In more specific terms, to load object 21, moving device 40b moves object 21 placed on placing section 40c to storage section 42. Moving device 40b can also move object 21 stored in storage section 42 to placing section 40c to unload object 21. This enables unloading of object 21.

As shown in Figs. 3B and 3C, when viewed in the vertical direction (Z-axis direction), moving unit 40b of this embodiment is located on the inner side of the storage units (first storage units 42t1 and second storage units 42t2). Moving device 40b can take various forms, as long as it can move object 21. Moving device 40b can, for example, use a robot arm (articulated robot), elevator slide mechanism, or other device. As shown in Fig. 3C, if object 21 is reel 21a, it is desirable to provide moving device 40b with elevator section 40b1 and gripping section 40b2.

Elevator section 40b1 can rotate around the axis line in the vertical direction (Z-axis direction) and can lift and lower gripping section 40b2 in the vertical direction (Z-axis direction). Gripping section 40b2 can move forward and backward at the same angle as tilt angle θ1 of the placing section 40c shown in Fig. 4. Gripping section 40b2 can also move forward and backward at the same angle as tilt angle θ1 of partition section 42b of storage section 42.

Thus, in storage compartment 40 of this embodiment, tilt angle θ1 of placing section 40c matches tilt angle θ1 of partition section 42b of storage section 42. This enables storage compartment 40 of this embodiment to perform the withdrawal operation of withdrawing reel 21a from placing section 40c when loading is performed, as well as to perform the storing operation of storing the withdrawn reel 21a in storage section 42 when loading is performed, through the actions of lifting, lowering, rotating, and moving forward and backward performed by moving unit 40b. This also enables storage compartment 40 of this embodiment to perform the withdrawal operation of withdrawing reel 21a from a storage unit when unloading is performed, as well as the sending operation of sending the withdrawn reel 21a to placing section 40c when unloading is performed, through the actions of lifting, lowering, rotating, and moving forward and backward performed by moving unit 40b.

Display device 40e enables operators to view data, and can consist of any known display device. Display unit 40e displays data such as object information about object 21 stored in storage section 42 in response to operations by the operator. Display device 40e of this embodiment is composed of a touch panel. Display device 40e also functions as an input device that is operated by the operator.

Control device 40a can record location information, loading-unloading information, and storage information of object 21 in storage section 42, and display section 40e can display this information. Location information indicates the storage location of object 21. Loading-unloading information indicates the loading and unloading dates and times of object 21. Storage information includes such information as the ambient temperature and humidity of storage section 42. Control device 40a records the location and loading date and time at which object 21 was loaded. Control device 40a records storage information while object 21 is in storage. Control device 40a records the unloading date and time at which object 21 was unloaded.

### 1-3-2. Object 21 loading-unloading control example

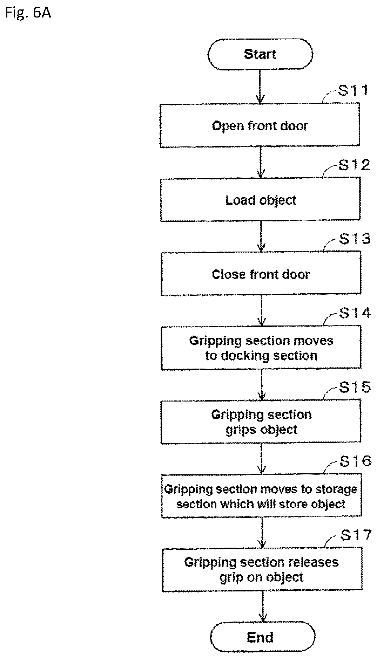

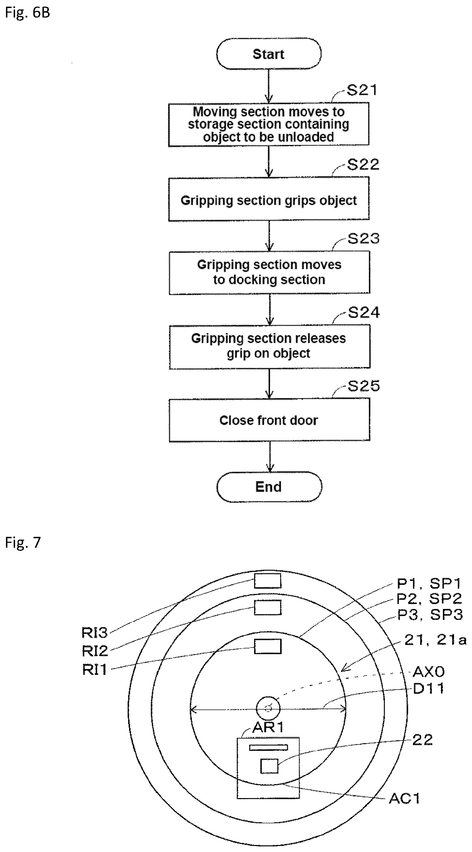

As shown in Fig. 5, when considered as a control block, control device 40a is equipped with moving section 51, guiding section 52, and dimension acquiring section 53. Control device 40a executes control programs in accordance with the flowcharts shown in Figs. 6A and 6B. Fig. 6A shows an example of a control procedure for loading object 21. Fig. 6B shows an example of a control procedure for unloading object 21.

Moving section 51 moves object 21 loaded in loading section 41 to storage section 42. In more specific terms, when loading object 21, moving section 51 moves object 21 placed on placing section 40c to storage section 42 using moving device 40b. When unloading object 21, moving section 51 can move object 21 stored in storage section 42 to placing section 40c using moving device 40b. Moving section 51 drives and controls moving device 40b to move object 21.

A front door is provided between aperture section 41a and placing section 40c. For example, control device 40a prohibits loading and unloading of object 21 through aperture section 41a while operation is underway or when operation is scheduled to be performed during a given interval at placing section 40c of moving device 40b. At such times, control device 40a closes the front door. Conversely, control device 40a allows loading and unloading of object 21 through aperture section 41a when no operation is underway or when no operation is scheduled during a given interval at placing section 40c of moving device 40b. At such times, control device 40a opens the front door.

When loading object 21 (for example, reel 21a), an operator uses a touch panel (display device 40e functioning as an input device) to command the front door to open. Control device 40a opens the front door when object 21 loading operations are allowed (Step S11 shown in Fig. 6A). When the front door is in an open state, the operator places reel 21a in given placing position P1 of placing section 40c via aperture section 41a (Step S12). At this time, guiding section 52 displays placing positions P1, P2, and P3, which each accommodate one type of reel 21a having external dimensions that differ from the other types of reel, on placing section 40c to guide the operator to select the placing position P1 in which the reel 21a to be loaded can be placed. Once reel 21a has been loaded, the operator uses the touch panel to notify control device 40a that loading is complete. Once notified that loading is complete, control device 40a closes the front door (Step S13).

Once the front door is closed, moving section 51 moves gripping section 40b2 of moving device 40b to placing section 40c (Step S14). In more specific terms, elevator section 40b1 of moving device 40b rotates as needed to enable gripping section 40b2 to reach reel 21a placed on placing section 40c when gripping section 40b2 moves forward, and raises gripping section 40b2 in the vertical direction (Z-axis direction). Next, gripping section 40b2 moves forward, grips reel 21a, and withdraws reel 21a while gripping reel 21a (Step S15).

After the withdrawal operation described above is completed during loading, moving section 51 moves gripping section 40b2 to the storage section 42 where reel 21a will be stored (Step S16). In more specific terms, elevator section 40b1 rotates as needed to enable gripping section 40b2 to reach a given storage location (pair of partition sections 42b containing first storage units 42t1 or second storage units 42t2) when gripping section 40b2 moves forward, and raises gripping section 40b2 in the vertical direction (Z-axis direction). Next, gripping section 40b2 moves forward and inserts reel 21a into the destination storage location (pair of partition sections 42b), releases its grip on reel 21a, and moves backward (Step S17). Performing the storing operation described above during loading stores reel 21a, which is object 21 in this case, in storage section 42.

When unloading object 21 (for example, reel 21a), an operator uses a touch panel to designate a reel 21a to be unloaded from storage compartment 40. Moving section 51 moves gripping section 40b2 to the storage section 42 in which the specified reel 21a is stored (Step S21 shown in Fig. 6B). In more specific terms, elevator section 40b1 rotates as needed to enable gripping section 40b2 to reach a reel 21a stored in a given storage location (pair of partition sections 42b) when gripping section 402b moves forward, and raises gripping section 40b2 in the vertical direction (Z-axis direction).

Next, gripping section 40b2 moves forward and grips the reel 21a stored in the storage location (pair of partition sections 42b), and moves backward while gripping reel 21a (Step S22). When unloading as described above, once the withdrawal operation is completed, moving section 51 moves gripping section 40b2 to placing section 40c (Step S23). In more specific terms, elevator section 40b1 rotates as needed to enable reel 21a gripped in gripping section 40b2 to reach placing section 40c when gripping section 402b moves forward, and raises gripping section 40b2 in the vertical direction (Z-axis direction).

Next, gripping section 40b2 moves forward, moves reel 21a to placing section 40c, releases its grip on reel 21a, and moves backward (Step S24). When unloading as described above, once the sending operation is completed, a back door provided between placing section 40c and moving device 40b is closed. Next, control device 40a opens the front door, enabling an operator to unload reel 21a through aperture section 41a (Step S25).

### 1-3-3. Example of object 21 placing position guidance

Guiding section 52 displays placing positions P1, P2, and P3, which each accommodate one type of reel 21a having external dimensions that differ from the other types of reel, on placing section 40c to guide the operator to select the placing position P1 in which the reel 21a to be loaded can be placed.

For example, guiding section 52 can use the projecting device 43 shown in Fig. 4 to project external shapes SP1, SP2, and SP3, each representing one type of object 21, from above placing section 40c. Projecting device 43 can consist of any known projecting device, such as a projector. Fig. 7 shows an example of placing positions P1, P2, and P3, each accommodating one type of object 21 (reel 21a), and external shapes SP1, SP2, and SP3, each representing one type of object 21, which are projected onto placing section 40c.

In more specific terms, guiding section 52 uses projecting device 43 to project onto placing section 40c external shape SP1 of a reel 21a of the reel diameter shown in diameter D11, to indicate placing position P1 on placing section 40c for the object 21a. Guiding section 52 also uses projecting device 43 to project onto placing section 40c external shape SP2 of a reel 21a with a diameter larger than that of the reel 21a represented by external shape SP1, to indicate placing position P2 on placing section 40c for the object 21a.

Guiding section 52 also uses projecting device 43 to project onto placing section 40c external shape SP3 of a reel 21a with a diameter larger than that of the reel 21a represented by external shape SP2, to indicate placing position P3 on placing section 40c for the object 21a. If object 21a is a reel 21a, external shapes SP1, SP2, and SP3 will each be in the form of a circle, and in this embodiment, will be shown as three concentric circles of varying diameters in the projection. Projected external shapes SP1, SP2, and SP3 can also be segments of a circle (arcs).

For example, when docking on placing section 40c a reel 21a of the reel diameter shown in diameter D11, docking the reel 21a in the position indicated by projected external shape SP1 enables the reel 21a to be placed in placing position P1, which is the correct placing position. The same is true when an operator places a reel 21a with a correct placing position of P2. The same is true when an operator places a reel 21a with a correct placing position of P3. The number of types of placing position that can be shown on placing section 40c by guiding section 52 is not limited to three types, and can be just one type, or a number of types that is not three.

As shown in Fig. 4, placing section 40c of this embodiment is tilted upward at a given angle (tilt angle θ1) with respect to the horizontal plane. Depending on the direction from which external shapes SP1, SP2, and SP3 of reel 21a are projected by projecting device 43, the operator may not be able to perform a correct visual confirmation of external shapes SP1, SP2, and SP3 of reel 21a. For example, if the projection direction is in the direction of rotation axis AX0 of reel 21a, when projecting device 43 projects a circular shape, the circular shape SP10 shown in Fig. 8 will be projected onto placing section 40c. This allows the operator to visually confirm circular shape SP10 as the external shape of reel 21a.

However, if the projection direction is in the vertical direction (Z-axis direction), when projecting device 43 projects a circular shape, the elliptical shape SP11 shown in Fig. 8 will be projected onto placing section 40c. This will not allow the operator to visually confirm circular shape SP10 as the external shape of reel 21a. To address this problem, it is desirable for guiding section 52 to alter the external shapes SP1, SP2, and SP3 which are projected onto placing section 40c to align them with tilt angle θ1 of placing section 40c to enable the operator to visually confirm the external shapes SP1, SP2, and SP3 of object 21 which are projected onto placing section 40c. This enables the operator to visually confirm external shapes SP1, SP2, and SP3 of objects 21 projected onto placing section 40c.

In the above example, guiding section 52 uses projecting device 43 to project the elliptical shape SP12 shown in Fig. 8 from a direction aligned with the vertical direction (Z-axis direction). This enables projection of the elliptical shape SP10 shown in Fig. 8 onto placing section 40c, allowing the operator to visually confirm elliptical shape SP10 as the external shape of reel 21a. The major diameter (length of major axis) of elliptical shape SP12 is set to match the diameter of round shape SP10. The minor diameter (length of minor axis) of elliptical shape SP12 is set in such a way that it appears to be round shape SP10 when projected onto placing section 40c. The larger the tilt angle θ1 of placing section 40c, the smaller the minor axis of elliptical shape SP12 is set.

Guiding section 52 can also use a different light color for each external shape when projecting external shapes SP1, SP2, and SP3 of object 21. In more specific terms, guiding section 52 uses projecting device 43 to project external shape SP1 using a light beam of a given wavelength (a first wavelength). Guiding section 52 also uses projecting device 43 to project external shape SP2 using a light beam of a given wavelength (a second wavelength) that differs from the first wavelength. Guiding section 52 also uses projecting device 43 to project external shape SP3 using a light beam of a given wavelength (a third wavelength) that differs from the first wavelength and the second wavelength. This enables the operator to easily distinguish between external shapes SP1, SP2, and SP3 representing different types of object 21.

Guiding section 52, in addition to external shapes SP1, SP2, and SP3 of object 21, can display related information RI1, RI2, and RI3 to indicate information related to object 21. The operator can refer to related information RI1, RI2, and RI3 as they visually confirm external shapes SP1, SP2, and SP3, each representing one type of object 21. Related information RI1, RI2, and RI3 can consist of any information as long as it is information related to object 21.

For example, if object 21 is reel 21a, related information RI1, RI2, and RI3 can include information such as the following about multiple types (three in this case) of reels 21a: reel diameter, reel thickness, types of components stored on reel 21a, model, and supplier (vendor). Reel diameter corresponds to the width and depth dimensions of object 21, and reel thickness corresponds to the height dimension of object 21. Related information RI1, RI2, and RI3 can thus include information about the external dimensions of object 21. This enables the operator to refer to information about the external dimensions of object 21, making it easier to visually confirm placing positions P1, P2, and P3, which each accommodate one type of object 21 having external dimensions that differ from the other types of object 21.

Guiding section 52 can also display related information RI1, RI2, and RI3 of object 21 in a language matching the language used by the operator. This makes it easier for each operator to recognize related information RI1, RI2, and RI3, even if, for example, multiple workers using different languages are loading object 21.

For example, storage compartment 40 of this embodiment is provided with display device 40e that functions as an input device to receive operations performed by an operator. When starting an operation, the operator can use display device 40e to select the language to be displayed on display device 40e. Guiding section 52 can, for example, display related information RI1, RI2, and RI3 about object 21 in the language selected by the operator when the operator started an operation. When displaying related information RI1, RI2, and RI3 on placing section 40c, guiding section 52 can use display device 40e to request operator input indicating the language to be used.

If an object 21 is already placed on placing section 40c, the operator cannot place another loaded object 21 on placing section 40c. As previously described, loading of object 21 through aperture section 41a is allowed if no operation is underway or when no operation is scheduled to be performed during a given interval at placing section 40c of moving device 40b. Guiding section 52 can thus display placing positions P1, P2, and P3, which each accommodate one type of object 21, when the following display conditions are met: object 21 is not placed on placing section 40c, and no operation is underway or scheduled to be performed during a given interval at placing section 40c of moving device 40b. This enables guiding section 52 to display placing positions P1, P2, and P3 when there is a need to display placing positions P1, P2, and P3.

**It** is possible to use the measurement results of measurement device 45, for example, to determine whether object 21 is placed on placing section 40c. The measurement device 45 shown in Fig. 4 measures the external dimensions of object 21 loaded in loading section 41, the measurement being taken from above object 21. Measuring device 45 can consist of any known measuring device, such as an ultrasonic sensor, optical sensor, or three-dimensional measuring device. When an ultrasonic sensor is used as measuring device 45, measuring device 45 sends and receives ultrasonic waves from above object 21 with object 21 placed on placing section 40c. In more specific terms, measuring device 45 sends ultrasonic waves to object 21 in the vertical direction (Z-axis direction) from a head installed above object 21. Measuring device 45 receives, at the head, the ultrasonic waves reflected by object 21.

Measuring device 45 measures the time it takes for the ultrasonic waves reflected by object 21 to be received from object 21 after the ultrasonic waves are sent to object 21 to measure the distance from the head to object 21. Measuring device 45 then subtracts the measured distance from the head to object 21 from the previously acquired distance from the head to placing section 40c, and outputs the subtracted value (distance difference) as the height dimension of object 21. Measuring device 45 can also measure the width dimension and depth dimension of object 21 by moving the head in sequence above object 21, or by using multiple provided heads.

If object 21 is placed on placing section 40c, measuring device 45 outputs the height dimension of object 21. If object 21 is not placed on placing section 40c, measuring device 45 outputs a value of zero or a value near zero. If the object 21 height dimension measured by measuring device 45 is within the range of expected object 21 height dimensions, guiding section 52 can judge that object 21 is placed on placing section 40c. Conversely, if the object 21 height dimension measured by measuring device 45 is extremely small in comparison to the range of expected object 21 height dimensions (for example, a value of zero), guiding section 52 can judge that object 21 is not placed on placing section 40c.

If the display conditions are no longer met, guiding section 52 can suspend display of placing positions P1, P2, and P3. It is possible that an operator could place object 21 at one time and later change the object 21 placing position. Once object 21 is placed on placing section 40c, the display conditions are no longer met. If guiding section 52 suspends the display of placing positions P1, P2, and P3 when display conditions are no longer met, and does not later re-display placing positions P1, P2, and P3, it would be difficult for the operator to change the placing position of object 21.

To resolve this problem, it is desirable for guiding section 52 to wait for a given time interval after display conditions are no longer met before suspending display of placing positions P1, P2, and P3. This enables greater workability when an operator loads object 21. The given time interval can be set by timing an object 21 loading operation performed by an operator in advance, and setting the acquired measured value as the given time interval. Compared to the given interval for operations scheduled to be performed by moving device 40b, the given time interval may be too short to be sufficient.

For example, an operator unfamiliar with loading may require more time to perform loading work than the measured value above. The more unfamiliar with loading the operator, the more the operator needs placing positions P1, P2, and P3 displayed. To resolve this problem, it is desirable to configure guiding section 52 so that when loading of object 21 by an operator is detected by operator detecting device 41b, guiding section 52 extends the given time interval or re-displays placing positions P1, P2, and P3 after the given time interval has elapsed. This enables guiding section 52 to suspend display of placing positions P1, P2, and P3 once the operator completes docking of object 21.

In more specific terms, if the operator repeatedly changes the placing position of object 21, operator detecting device 41b detects loading of object 21 through aperture section 41a by the operator. When loading of object 21 by the operator is detected by operator detecting device 41b, guiding section 52 extends the given time interval or re-displays placing positions P1, P2, and P3 once the given time interval has elapsed. When loading of object 21 by the operator is completed, operator detecting device 41b no longer detects loading of object 21 by an operator. Guiding section 52 therefore suspends display of placing positions P1, P2, and P3.

Storage compartment 40 of this embodiment is provided with imaging device 46 to capture object 21 placed on placing section 40c. Dimension acquiring section 53 causes imaging device 46 to capture an image of at least a portion of object 21 placed on placing section 40c, and acquires the external dimensions of object 21 by processing the image data acquired by imaging device 46.

Any known imaging device can be used as imaging device 46 as long as it can capture an image of object 21 placed on placing section 40c. As shown in Fig. 4, imaging device 46 of this embodiment is secured to a base above placing section 40c in such a way that the optical axis is in the vertical direction. Area AR1 in Fig. 7 shows an example of the field of view of imaging device 46. Dimension acquiring section 53 acquires the external dimensions of object 21 by processing image data acquired by imaging device 46.

Any known method of image processing can be used. Dimension acquiring section 53 acquires diameter D11 of reel 21a by, for example, recognizing the external shape of the main body section of reel 21a by such image processing methods as binarization, and measuring diameter DII of reel 21a.

The captured image shown in area AR1 of Fig. 7 is a portion of reel 21a placed on placing section 40c; the captured image of the outer edge of reel 21a is shown as arc AC1. In this case, dimension acquiring section 53 cannot directly measure diameter D11 of reel 21a. To resolve this problem, dimension acquiring section 53 estimates diameter D11 of reel 21a by recognizing a portion of reel 21a (arc AC1) and using that data to calculate diameter D11 of reel 21a. In more specific terms, dimension acquiring section 53 can, for example, calculate the radius of curvature of the circle indicating the outer edge of reel 21a based on arc AC1, and use that data to estimate diameter D11 of reel 21a.

When imaging device 46 captures an image of object 21, if placing positions P1, P2, and P3 are being displayed, the display of placing positions P1, P2, and P3 could be misrecognized as the external shape of object 21 (outer edge of reel 21a). To resolve this problem, guiding section 52 suspends display of placing positions P1, P2, and P3 while imaging device 46 captures an image of object 21. This enables guiding section 52 to reduce the risk of misrecognition of the external shape of object 21 (outer edge edge of reel 21a).

Imaging device 46 of this embodiment also functions as reading device 40d, which reads ID code 22 attached to reel 21a. For this reason, ID code 22 is included in region AR2. This enables dimension acquiring section 53 to acquire diameter D11 of reel 21a when it acquires identifying information that identifies reel 21a. Rather than installing imaging device 46 separately, providing the storage compartment 40 of this embodiment reduces device size and allows efficient use of work space above placing section 40c.

### 1-4. Modified Embodiments

In any of the embodiments described above, storage compartment 40 may be provided with light-emitting device 44 instead of projecting device 43. Guiding section 52, using light-emitting device 44, can cause light-emitting element 44a located in placing section 40c to emit light in the form of external shapes SP1, SP2, and SP3 of each type of object 21. Light-emitting element 44a can consist of any known light-emitting element, such as a light-emitting diode (LED).

In the embodiment, object 21 is a reel 21a, and guiding section 52 projects external shapes SP1, SP2, and SP3, representing three types of reel 21a, as concentric circles. In this case, light-emitting elements 44a are arranged in concentric circles matching external shapes SP1, SP2, or SP3. Light-emitting device 44 drives and controls the lighting and extinguishing of light-emitting elements 44a. Light-emitting device 44 causes light-emitting elements 44a to emit light when a light-emitting element 44a light-emitting command is received from guiding section 52. Light-emitting device 44 causes light-emitting elements 44 to extinguish light when a light-emitting element 44a light-extinguishing command is received from guiding section 52.

Fig. 9 shows a schematic view of the display of placing positions P1, P2, and P3, each accommodating one type of object 21, and external shapes SP1, SP2, and SP3, each representing one type of object 21, which is formed by the emitting of light by light-emitting elements 44a. The number and layout of light-emitting elements 44a can be changed as needed. In Fig. 9, for convenience, only a portion of the light-emitting elements 44a have been assigned code numbers, and not all light-emitting elements 44a have code numbers.

In this embodiment, guiding section 52 can use a different light color for each external shape SP1, SP2, and SP3 of object 21. Guiding section 52, in addition to external shapes SP1, SP2, and SP3 of object 21, can display RI1, RI2, and RI3 to indicate information related to object 21. Guiding section 52 can display related information RI1, RI2, and RI3 of object 21 in a language matching the language used by the operator. As in the embodiment, guiding section 52 can display placing positions P1, P2, and P3 and can suspend display of placing positions P1, P2, and P3.

Restraining members can be installed, for example, in placing positions P1, P2, and P3 of placing section 40c. Restraining members are installed in each placing position, including P1, P2, and P3, and restrain the docking of an object 21 having external dimensions which differ from the external dimensions of the object 21 which should be placed in that position. In an embodiment wherein restraining members are installed in placing section 40c, the display of placing positions P1, P2, and P3 by guiding section 52 may not be necessary. However, if objects 21 having external dimensions similar to each other can be placed on multiple placing positions, it is desirable to apply the items mentioned in the disclosed embodiment and the modified embodiments. The same is true for cases in which placing positions P1, P2, and P3 are at different height positions.

For example, guiding section 52 can also use display device 40e to display information guiding an operator to place object 21 in accordance with the placing positions P1, P2, and P3 that are displayed on placing section 40c. The operator can also use display device 40e to select the type and number of placing positions P1, P2, and P3 to be displayed on placing section 40c. The operator can also use display device 40e to select the type and number of related information RI1, RI2 and RI3 to be displayed on placing section 40c.

### 1-5. Other

Examples described in the embodiments and modified embodiments primarily use reel 21a to represent object 21. However, object 21 can also include, for example, feeder 21b, tray 21c, solder container 21d, a holding member, or a holding member storage device. Storage compartment 40 can be provided with storage units compatible with the particular object 21 to be stored, and with moving devices compatible with the particular object 21 to be moved.

### 2. Example of the Effects of the Embodiments

Depending on the storage compartment 40, storage compartment 40 is provided with placing section 40c, guiding section 52, storage section 42, and moving section 51. This enables storage unit 40 to automate the storage operation of storing loaded object 21 in storage section 42, and also enables storage unit 40 to provide guidance to the operator on the correct loading position based on the type of object, for objects with varying external dimensions.

### Reference Signs List

10: board work machine; 21: object; 40: storage compartment; 40b: moving device;
40c: placing section; 41a: aperture section; 41b: operator detecting device; 42: storage section;
43: projecting device; 44: light-emitting device; 44a: light-emitting element; 46: imaging device;
51: moving section; 52: guiding section; 53: dimension acquiring section; 90: board;
P1, P2, P3: loading position; RI1, RI2, RI3: related information;
SP1, SP2, SP3: external shapes; θ1: tilt angle

## Claims

1. A storage compartment (40) comprising:
a placing section (40c) on which an object (21) is temporarily placed when the object (40c) is being received to be used by a board work machine (10) that is configured to perform given board work on a board (90);
a guiding section (52) configured to display on the placing section a placement position for each type of the object (21) with external dimensions that differ from other types of the objects (21) to guide an operator to select the placement position that can accommodate the object (21) such that the placing position enables a moving section to handle the object (21);
a storage section (42) that is configured to store the object (21); and
the moving section (51) that is configured to move the object (21) placed on the placing section (40c) to the storage section (42)
**characterized in that:**
the guiding section (52) uses a projecting device (43) to project an external shape of each type of the object (21) from above the placing section (40c), or
the guiding section (52) is configured to use a light-emitting device (44) to cause a light-emitting element (44a) provided in the placing section (40c) to emit light in a form of the external shape of each type of object (21).

2. The storage compartment (40) according to Claim 1, wherein
the placing section (40c) is installed at a given tilt angle (θ1) with respect to a horizontal plane, and
the guiding section (52) alters the external shapes (S1, S2, S3), which are projected onto the placing section (40c), to align with the tilt angle (θ1) of the placing section (40c) to enable the operator to visually confirm the external shapes (S1, S2, S3) which are projected onto the placing section (40c).

3. The storage compartment (40) according to Claim 1 or Claim 2, wherein
the guiding section (52) is configured to use a different light color for each external shape of the object (21).

4. The storage compartment (40) according to any one of Claim 1 to Claim 3, wherein
the guiding section (52) is configured to display the external shape of the object (21) together with related information (RI1, RI2, RI3) about the object (21).

5. The storage compartment (40) according to Claim 4, wherein
the guiding section (52) is configured to display the related information (RI1, RI2, RI3) about the object (21) in a language matching a language used by the operator.

6. The storage compartment (40) according to any one of Claim 1 to Claim 5, wherein
the moving section (51) is configured to use a moving device (40b) to move the object (21) to the storage section (42), and
the guiding section (52) is configured to display placing positions which each accommodate one type of object (21) when display conditions are met, the display conditions being an object (21) is not placing on the placing section (40c), and no operation is underway or scheduled to be performed during a given interval at the placing section (40c) of the moving device (40b).

7. The storage compartment (40) according to Claim 6, wherein
the guiding section (52) is configured to suspend display of the placing positions after a given time interval has elapsed since the display conditions were no longer met.

8. The storage compartment (40) according to Claim 7, further provided with
an operator detecting device (41b) configured to detect loading of the object (21) through an aperture section (41a) through which the object (21) is loaded by the operator, and wherein
the guiding section (52) extends the given time interval or re-displays the placing positions once the given time interval has elapsed when loading of the object (21) by the operator is detected by the operator detecting device (41b).

9. The storage compartment (40) according to any one of Claim 6 to Claim 8, further provided with
an imaging device (46) configured to capture an image of the object (21) placed on the placing section (40c); and
a dimension acquiring section (53) which causes the imaging device (46) to capture an image of at least a portion of the object (21) placing on the placing section (40c), and acquires the external dimensions of the object (21) by processing the image data acquired by the imaging device (46); wherein
the guiding section (52) suspends display of the placing positions while the imaging device (46) captures an image of the object (21).

## Patentansprüche

1. Ein Ablagefach (40) umfassend:
einen Platzierungsabschnitt (40c), auf dem ein Objekt (21) vorübergehend platziert wird, wenn das Objekt (40c) aufgenommen wird, um von einer Plattenbearbeitungsmaschine (10) verwendet zu werden, die konfiguriert ist, eine bestimmte Plattenbearbeitung an einer Platte (90) durchzuführen;
einen Führungsabschnitt (52), der konfiguriert ist, auf dem Platzierungsabschnitt eine Platzierungsposition für jeden Typ des Objekts (21) mit Außenabmessungen anzuzeigen, die sich von anderen Typen der Objekte (21) unterscheiden, um einen Bediener anzuleiten, die Platzierungsposition auszuwählen, die das Objekt (21) aufnehmen kann, so dass die Platzierungsposition es einem Bewegungsabschnitt ermöglicht, das Objekt (21) zu handhaben;
einen Lagerabschnitt (42), der konfiguriert ist, das Objekt (21) zu lagern; und
den Bewegungsabschnitt (51), der konfiguriert ist, das auf dem Platzierungsabschnitt (40c) platzierte Objekt (21) zu dem Lagerabschnitt (42) zu bewegen.
**gekennzeichnet dadurch, dass:**
der Führungsabschnitt (52) eine Projektionsvorrichtung (43) verwendet, um eine äußere Form jedes Typs des Objekts (21) von oberhalb des Platzierungsabschnitts (40c) zu projizieren, oder
der Führungsabschnitt (52) konfiguriert ist, eine lichtemittierende Vorrichtung (44) zu verwenden, um ein lichtemittierendes Element (44a), das in dem Platzierungsabschnitt (40c) angeordnet ist, zu veranlassen, Licht in Form der äußeren Form jedes Typs des Objekts (21) zu emittieren.

2. Das Ablagefach (40) gemäß Anspruch 1, wobei
der Platzierungsabschnitt (40c) in einem gegebenen Neigungswinkel (θ1) in Bezug auf eine horizontale Ebene installiert ist, und
der Führungsabschnitt (52) die äußeren Formen (S1, S2, S3), die auf den Platzierungsabschnitt (40c) projiziert werden, so verändert, dass sie mit dem Neigungswinkel (θ1) des Platzierungsabschnitts (40c) übereinstimmen, um dem Bediener zu ermöglichen, die äußeren Formen (S1, S2, S3), die auf den Platzierungsabschnitt (40c) projiziert werden, visuell zu bestätigen.

3. Das Ablagefach (40) gemäß Anspruch 1 der Anspruch 2, wobei
der Führungsabschnitt (52) konfiguriert ist, für jede Außenform des Objekts (21) eine andere Lichtfarbe zu verwenden.

4. Das Ablagefach (40) gemäß einem der Ansprüche 1 bis 3, wobei
der Führungsabschnitt (52) konfiguriert ist, die äußere Form des Objekts (21) zusammen mit zugehörigen Informationen (RI1, RI2, RI3) über das Objekt (21) anzuzeigen.

5. Das Ablagefach (40) gemäß Anspruch 4, wobei
der Führungsabschnitt (52) konfiguriert ist, die zugehörigen Informationen (RI1, RI2, RI3) über das Objekt (21) in einer Sprache anzuzeigen, die mit einer vom Bediener verwendeten Sprache übereinstimmt.

6. Das Ablagefach (40) gemäß einem der Ansprüche 1 bis 5, wobei
der Bewegungsabschnitt (51) konfiguriert ist, eine Bewegungsvorrichtung (40b) zu verwenden, um das Objekt (21) zu dem Lagerabschnitt (42) zu bewegen, und
der Führungsabschnitt (52) konfiguriert ist, Ablagepositionen anzuzeigen, die jeweils einen Typ von Objekt (21) aufnehmen, wenn Anzeigebedingungen erfüllt sind, wobei die Anzeigebedingungen darin bestehen, dass ein Objekt (21) nicht auf dem Platzierungsabschnitt (40c) platziert wird und dass während eines gegebenen Intervalls an dem Platzierungsabschnitt (40c) der Bewegungsvorrichtung (40b) kein Vorgang im Gange ist oder geplant ist, durchgeführt zu werden.

7. Das Ablagefach (40) gemäß Anspruch 6, wobei
der Führungsabschnitt (52) konfiguriert ist, die Anzeige der Ablagepositionen auszusetzen, nachdem ein gegebenes Zeitintervall verstrichen ist, seit die Anzeigebedingungen nicht mehr erfüllt wurden.

8. Das Ablagefach (40) gemäß Anspruch 7, des Weiteren umfassend eine Bediener-Erfassungsvorrichtung (41b), die konfiguriert ist, das Laden des Objekts (21) durch einen Öffnungsabschnitt (41a) zu erfassen, durch den das Objekt (21) von dem Bediener geladen wird, und wobei
der Führungsabschnitt (52) das gegebene Zeitintervall verlängert oder die Platzierungspositionen erneut anzeigt, sobald das gegebene Zeitintervall verstrichen ist, wenn das Laden des Objekts (21) durch den Bediener von der Bediener-Erfassungsvorrichtung (41b) erfasst wird.

9. Das Ablagefach (40) gemäß einem der Ansprüche 6 bis 8, des Weiteren umfassend
eine Abbildungsvorrichtung (46), die konfiguriert ist, ein Bild des auf dem Platzierungsabschnitt (40c) platzierten Objekts (21) zu erfassen; und
einen Abmessungserfassungsabschnitt (53), der die Abbildungsvorrichtung (46) veranlasst, ein Bild von mindestens einem Teil des auf dem Platzierungsabschnitt (40c) platzierten Objekts (21) zu erfassen, und die Außenabmessungen des Objekts (21) durch Verarbeiten der von der Abbildungsvorrichtung (46) erfassten Bilddaten erfasst; wobei
der Führungsabschnitt (52) die Anzeige der Platzierungspositionen unterbricht, während die Abbildungsvorrichtung (46) ein Bild des Objekts (21) erfasst.

## Revendications

1. Compartiment de stockage (40) comprenant :
une section de placement (40c) sur laquelle un objet (21) est temporairement placé lorsque l'objet (40c) est reçu pour être utilisé par une machine de travail de carte (10) qui est configurée pour effectuer un travail de carte donné sur une carte (90) ;
une section de guidage (52) configurée pour afficher sur la section de placement une position de placement pour chaque type de l'objet (21) avec des dimensions externes qui diffèrent d'autres types des objets (21) afin de guider un opérateur pour sélectionner la position de placement qui peut accueillir l'objet (21) de sorte que la position de placement permette à une section de déplacement de manipuler l'objet (21) ;
une section de stockage (42) qui est configurée pour stocker l'objet (21) ; et
la section de déplacement (51) qui est configurée pour déplacer l'objet (21) placé sur la section de placement (40c) vers la section de stockage (42)
**caractérisé en ce que :**
la section de guidage (52) utilise un dispositif de projection (43) pour projeter une forme extérieure de chaque type de l'objet (21) depuis le dessus de la section de placement (40c), ou
la section de guidage (52) est configurée pour utiliser un dispositif électroluminescent (44) pour amener un élément électroluminescent (44a) prévu dans la section de placement (40c) à émettre de la lumière selon la forme externe de chaque type d'objet (21).

2. Compartiment de stockage (40) selon la revendication 1, dans lequel
la section de placement (40c) est installée selon un angle d'inclinaison donné (θ1) par rapport à un plan horizontal, et
la section de guidage (52) modifie les formes externes (S1, S2, S3) qui sont projetées sur la section de placement (40c) pour s'aligner avec l'angle d'inclinaison (θ1) de la section de placement (40c) afin de permettre à l'opérateur de confirmer visuellement les formes externes (S1, S2, S3) qui sont projetées sur la section de placement (40c).

3. Compartiment de stockage (40) selon la revendication 1 ou 2, dans lequel
la section de guidage (52) est configurée pour utiliser une couleur de lumière différente pour chaque forme externe de l'objet (21).

4. Compartiment de stockage (40) selon l'une quelconque des revendications 1 à 3, dans lequel
la section de guidage (52) est configurée pour afficher la forme externe de l'objet (21) conjointement avec des informations associées (RI1, RI2, RI3) concernant l'objet (21).

5. Compartiment de stockage (40) selon la revendication 4, dans lequel
la section de guidage (52) est configurée pour afficher les informations associées (RI1, RI2, RI3) concernant l'objet (21) dans une langue correspondant à la langue utilisée par l'opérateur.

6. Compartiment de stockage (40) selon l'une quelconque des revendications 1 à 5, dans lequel
la section de déplacement (51) est configurée pour utiliser un dispositif de déplacement (40b) pour déplacer l'objet (21) vers la section de stockage (42), et
la section de guidage (52) est configurée pour afficher des positions de placement qui accueillent chacune un type d'objet (21) lorsque des conditions d'affichage sont remplies, les conditions d'affichage étant que l'objet (21) n'est pas placé sur la section de placement (40c) et qu'aucune opération n'est en cours ou programmée pour être effectuée pendant un intervalle donné au niveau de la section de placement (40c) du dispositif de déplacement (40b).

7. Compartiment de stockage (40) selon la revendication 6, dans lequel
la section de guidage (52) est configurée pour suspendre l'affichage des positions de placement après qu'un intervalle de temps donné s'est écoulé depuis que les conditions d'affichage ne sont plus remplies.

8. Compartiment de stockage (40) selon la revendication 7, pourvu en outre
d'un dispositif de détection d'opérateur (41b) configuré pour détecter le chargement de l'objet (21) à travers une section d'ouverture (41a) par laquelle l'objet (21) est chargé par l'opérateur, et dans lequel
la section de guidage (52) prolonge l'intervalle de temps donné ou réaffiche les positions de placement une fois que l'intervalle de temps donné s'est écoulé lorsque le chargement de l'objet (21) par l'opérateur est détecté par le dispositif de détection d'opérateur (41b).

9. Compartiment de stockage (40) selon l'une quelconque des revendications 6 à 8, pourvu en outre
d'un dispositif d'imagerie (46) configuré pour capturer une image de l'objet (21) placé sur la section de placement (40c) ; et
d'une section d'acquisition de dimensions (53) qui amène le dispositif d'imagerie (46) à capturer une image d'au moins une partie de l'objet (21) placé sur la section de placement (40c), et qui acquiert les dimensions externes de l'objet (21) en traitant les données d'image acquises par le dispositif d'imagerie (46) ; dans lequel
la section de guidage (52) suspend l'affichage des positions de placement pendant que le dispositif d'imagerie (46) capture une image de l'objet (21).
